# EUROPEAN PATENT APPLICATION

(11) **EP 2 557 363 A2**
(43) Date of publication of application: **13.02.2013**
(21) Application number: 12178787.3
(22) Date of filing: 01.08.2012
(51) Int. Cl.: F24C 7/08

(54) **An electronic home appliance with sensor and mounting of such sensor**

(30) Priority: 08.08.2011 TR 201107844
(71) Applicant: Vestel Beyaz Esya Sanayi ve Ticaret A.S., 45030 Manisa (TR)
(72) Inventor: Ozcelikyildiz, Benal, 45030 Manisa (TR)
(74) Representative: Cayli, Hülya

(57) **Abstract**

The home appliance of the invention comprises a sensor (S) which comprises at least two legs (S1); a sensor holding element (B) in which the sensor (S) is placed; a connection surface (L) to which the sensor holding element (B) is connected; and a panel (P) which is able to be positioned on the sensor (S). The sensor holding element (B) comprises an upper surface (1) on which the sensor (S) is placed and which comprises openings (1a) for inserting the legs (S1) of the sensor (S); a lateral surface (2) which is in the cylindrical form whose diameter is narrowed as the distance from upper surface increases; a separator (4) which extends between openings (1 a) in the direction at which the lateral surface (2) extends; a connection element which is located at the low diameter side of the lateral surface (2) and which ensures the connection of the sensor holding element (B) to said connection surface (L).

## Description

### Technical Field

The present invention relates to electronic home appliances comprising a holding element used for fixing a sensor to a panel.

### Prior Art

In electronic home appliances, such as a cooking device, sensors are used for receiving information about the current status of the home appliance or of an item with which the home appliance is in interaction (e.g. a cooking pot on a cooking device), or for controlling the operation of the home appliance. These sensors are able to be fixed to at least one surface of the home appliance. The sensors of the state of the art are able to be fixed directly on a circuit board preferably by a printing method or via a connection element.

The patent document no EP1344983A2 of the state of the art discloses a control unit arrangement of a cooking hob. Buttons, sensitive to touch are provided in the control unit for determining temperature levels of the heating zones. These buttons are located directly on a circuit board. Touch sensing element mentioned in said document does not able to contact with a panel (e.g. an upper glass panel of a cooking device) directly when the panel is provided thereon. Therefore, when the panel is moved (e.g. slid a little from its place), the touch sensing element does not able to perform its function properly.

### Brief Description of the Invention

The home appliance of the present invention comprises at least one sensor comprising at least two legs; at least one sensor holding element in which the sensor is placed; at least one connection surface to which the sensor holding element is connected; and at least one panel which is able to be positioned on the sensor. Said sensor holding element comprises at least one upper surface on which said sensor is placed and which comprises at least two openings for inserting the legs of the sensor; at least one lateral surface which extends from the edge part of the upper surface in the opposite direction at which the sensor is placed and which is in the cylindrical form whose diameter is narrowed as the distance from upper surface increases; at least one separator which extends, in the direction at which the lateral surface (2) extends, between openings located on the upper surface so as to separate the legs from each other when the legs of the sensor are inserted into the openings (1a); at least one connection element which is located at the low diameter side of the lateral surface and which ensures the connection of the sensor holding element to said connection surface.

In the home appliance of the invention, the sensor holding element is in an elastic structure and is able to be compressed by being stretched when the panel is placed on the sensor. Thanks to the compression, when the panel is moved from its place, the sensor is able to be moved together with the panel. Therefore, it is ensured that the position of the panel with respect to the sensor is not changed.

### Objectives of the Invention

The main aim of the invention is to develop an electronic home appliance comprising at least one sensor holding element for fixing at least one sensor to at least one surface of the home appliance.

The other aim of the invention is to develop an electronic home appliance comprising at least one sensor holding element which ensures that the contact of the sensor with a panel is not interrupted when the panel is placed on the sensor.

Another aim of the invention is to develop an electronic home appliance comprising a reliable sensor holding element which is easy and practical to produce.

### Description of the Drawings

Exemplary embodiments of an electronic home appliance comprising the sensor holding element are shown in attached drawings, wherein:
Figure 1 is a lateral sectional view of a part of the home appliance where the sensor holding element is comprised.
Figure 2 is a perspective view of the sensor holding element which is used in the home appliance.
Figure 3 is a lateral sectional view of a part of the home appliance comprising an upper panel where the sensor holding element is comprised.

The parts in figures are individually enumerated and the corresponding terms of reference numbers are given as follows:

| | |
|---|---|
| Sensor | (S) |
| Leg | (S1) |
| Sensor holding element | (B) |
| Connection surface | (L) |
| Panel | (P) |
| Upper surface | (1) |
| Opening | (1a) |
| Lateral surface | (2) |
| Projection | (3) |
| Separator | (4) |

### Description of the Invention

The electronic home appliances, such as a cooking device or cooling device, are provided with at least one sensor for receiving information about the current status of the home appliance or of an item with which the home appliance is in interaction (e.g. a cooking pot in a cooking device), or for controlling the operation of the home appliance. This sensor is able to be fixed to at least one surface of the home appliance and at least one panel is able to be fixed on the sensor. However, when the panel is placed on the sensor, the sensor is not able to operate properly when the panel is moved with respect to the sensor. For this reason, the present invention discloses a home appliance comprising at least one sensor holding element which ensures fixed position of the sensor with respect to the panel.

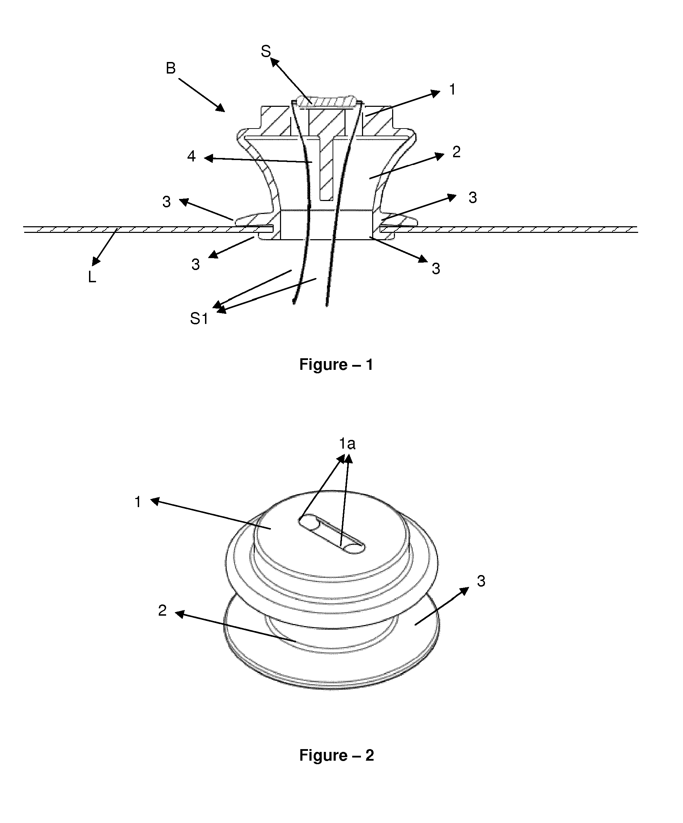

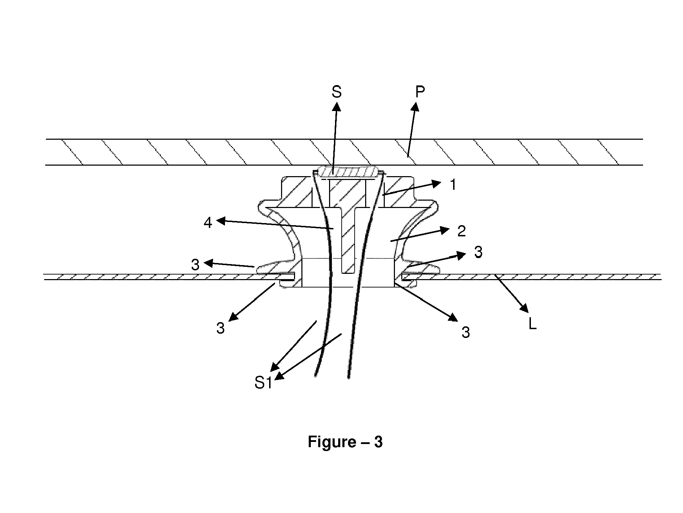

The home appliance (not shown in figures) of the invention comprises, as shown in figures 1 - 3, at least one sensor (S) comprising at least two legs (S1); at least one sensor holding element (B) in which the sensor (S) is placed; at least one connection surface (L) to which the sensor holding element (B) is connected; and at least one panel (P) which is able to be positioned on the sensor (S). Said sensor holding element (B) comprises at least one upper surface (1) on which said sensor is placed and which comprises at least two openings (1 a) for inserting legs (S1) of the sensor; at least one lateral surface (2) which extends preferably from the edge part of the upper surface (1) in the opposite direction at which the sensor (S) is placed and which is in the cylindrical form whose diameter is narrowed as the distance from upper surface increases; at least one separator (4) which extends, in the direction at which the lateral surface (2) extends, between openings (1 a) located on the upper surface (1) so as to separate these legs (S1) from each other when the legs (S1) of the sensor (S) are inserted into the openings (1 a); at least one connection element which is located at the low diameter side of the lateral surface (2) and which ensures the connection of the sensor holding element (B) to said connection surface (L).

The sensor holding element (B) used in the home appliance of the present invention is made of an elastic material such as plastic or rubber. Therefore, when a panel (P) is placed on the sensor (S), the lateral surface (2) of the sensor holding element (B) is compressed by being stretched. When the panel (P) is moved with respect to the sensor (S) (e.g. when the distance between the panel (P) and the sensor (S) is increased a little), thanks to the fact that stuck elastic lateral surface (2) tends to return to its position before being stuck by being stretched, it is ensured that the sensor (S) does not change its position with respect to the panel (P). Moreover, thanks to the fact that the lateral surface (2) is in the form of a cylinder whose diameter is narrowed as the distance from upper surface increases, the sticking of the upper surface (1) inside the lateral surface (2) is prevented during said sticking, in other words, the sensor holding element (B) becomes more reliable.

In a preferred embodiment of the invention, the connection element, which ensures the connection of the sensor holding element (B) to the connection surface (L), comprises at least two projections (3) extending from the lateral surface (2) towards outside. When the sensor holding element (B) is connected to the connection surface (L), the connection surface (L) remains stuck between the projections (3).

In another preferred embodiment of the invention, the sensor holding element (B) is in a uniform structure and produced by being taken out of a mold. Thus, it is easy and practical to produce the sensor holding element (B).

## Claims

1. An electronic home appliance comprising at least one sensor (S) which comprises at least two legs (S1); at least one sensor holding element (B) in which the sensor (S) is placed; at least one connection surface (L) to which the sensor holding element (B) is connected; and at least one panel (P) which is able to be positioned on the sensor (S) **characterized in that** said sensor holding element (B) comprises
- at least one upper surface (1) on which said sensor is placed and which comprises at least two openings (1 a) for inserting legs (S1) of the sensor (S);
- at least one lateral surface (2) which extends from the edge part of the upper surface (1) in the opposite direction at which the sensor (S) is placed and which is in the cylindrical form whose diameter is narrowed as the distance from upper surface increases ;
- at least one separator (4) which extends, in the direction at which the lateral surface (2) extends, between openings (1 a) located on the upper surface (1) so as to separate these legs (S1) from each other when the legs (S1) of the sensor (S) are inserted into the openings (1 a);
- at least one connection element which is located at the low diameter side of the lateral surface (2) and which ensures the connection of the sensor holding element (B) to said connection surface (L).

2. An electronic home appliance according to claim 1 **characterized in that** said connection element comprises at least two projections (3) extending from the lateral surface (2) such that the connection surface (L) is stuck therebetween.

3. An electronic home appliance according to claim 1 **characterized in that** the sensor holding element (B) is in a uniform structure.

4. An electronic home appliance according to claim 1 **characterized in that** the sensor holding element (B) is in an elastic structure.
